# EUROPÄISCHE PATENTANMELDUNG

(11) **EP 0 735 680 A1**
(43) Veröffentlichungstag der Anmeldung: **02.10.1996**
(21) Anmeldenummer: 95104826.3
(22) Anmeldetag: 31.03.1995
(51) Int. Cl.: H03K 5/26

(54) **Schaltungsanordnung für den Empfang von über einen 2-Draht-Bus übertragenen digitalen Signalen**

(71) Anmelder: TEXAS INSTRUMENTS DEUTSCHLAND GMBH, D-85356 Freising (DE)
(72) Erfinder: Bayer, Erich, 84030 Piflas (DE); Scoones, Kevin, 85368 Moosburg (DE)
(74) Vertreter: Schwepfinger, Karl-Heinz, Dipl.-Ing.

(57) **Zusammenfassung**

Eine Schaltungsanordnung für den Empfang von über einen 2-Draht-Bus übertragenen digitalen Signalen enthält zwei Eingänge (14, 22) und einen Ausgang (18) sowie einen Flankendetektor (12, 20) an jedem Eingang (14, 22). Jeder Flankendetektor gibt abhängig von einer an seinem Ausgang auftretenden Signalflanke ein Ausgangssignal ab. Eine Verknüpfungsschaltung (16) schaltet jedes von einem Flankendetektor (12, 20) abgegebene Signal zum Ausgang (18) durch, und eine Zeitmeßschaltung (28, 30, 36, 38) mißt den zeitlichen Abstand der von den Flankendetektoren (12, 20) abgegebenen Signale. Der Flankendetektor (12, 20) gibt ein Fehlersignal ab, wenn der gemessene zeitliche Abstand größer als der maximale Flankenabstand zwischen zwei aufeinanderfolgenden digitalen Signalen am Bus ist. Das Auftreten eines Fehlersignals markiert das zuvor empfangene digitale Signal als ungültig.

## Beschreibung

Die Erfindung bezieht sich auf eine Schaltungsanordnung für den Empfang von über einen 2-Draht-Bus übertragenen digitalen Signalen mit zwei Eingängen und einem Ausgang sowie einem Flankendetektor an jedem Eingang, der abhängig von einer an seinem Eingang auftretenden Signalflanke ein Ausgangssignal abgibt.

Für die Übertragung digitaler Signale können 2-Draht-Busse verwendet werden, um die Übertragungssicherheit zu vergrößern. Im Idealfall erfolgt die Signalübertragung auf den beiden Adern des Busses spiegelbildlich, d.h. daß bei der Übertragung eines Signals mit dem Wert "1" auf einer Ader gleichzeitig ein Signal mit dem Wert "0" auf der anderen Ader übertragen wird. Die Flanken der Signale treten dabei jeweils gleichzeitig auf, und mit Hilfe von Flankendetektoren kann in einem Signalempfänger die Signalerkennung und deren Auswertung vorgenommen werden. In der EP-Patentanmeldung 95102169.0 ist beschrieben, wie die Signalerkennung und -auswertung unter Verwendung eines mit jeder Ader des Busses verbundenen Flankendetektors erfolgen kann. Ein geeigneter Flankendetektor ist in der EP-Patentanmeldung 94120271.5 beschrieben.

In einem in der Praxis eingesetzten 2-Draht-Bus liegen jedoch selten ideale Verhältnisse mit völlig symmetrischen Signalen an beiden Adern vor. Es kann vielmehr vorkommen, daß die beiden Adern des Busses unsymmetrisch angesteuert werden und daß unterschiedliche Amplituden an den Adern vorhanden sind. Die aufgrund der unvermeidbaren Kapazitäten zwischen den Adern vorhandene gegenseitige Beeinflussung der Signale kann zu Schwierigkeiten beim Erkennen und Auswerten der Signale in dem vom Bus gespeisten Signalempfänger führen.

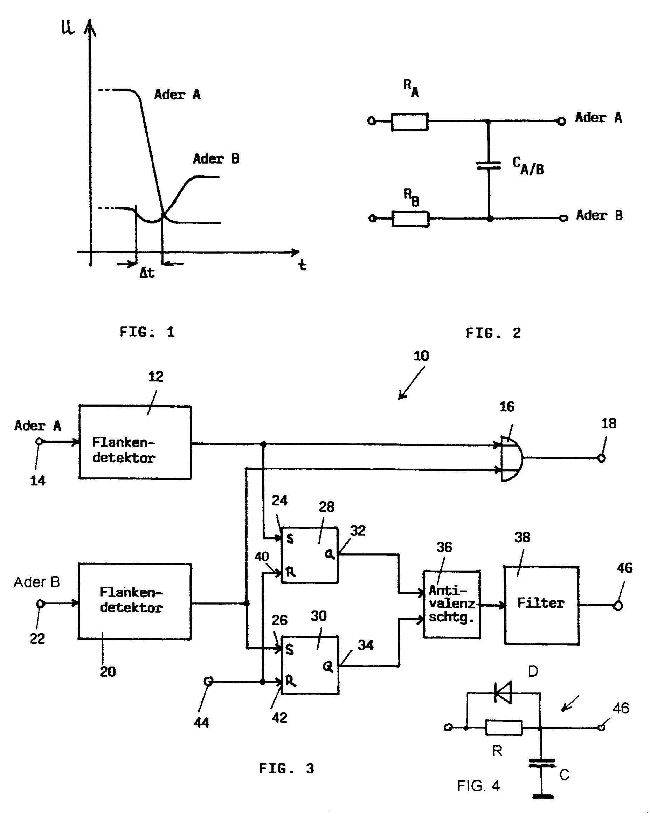

In Fig. 1 ist ein Spannungs-Zeit-Diagramm dargestellt, das einen kleinen Abschnitt eines an der Ader A und an der Ader B eines Busses übertragenen Signals zeigt. Die Signale sind dabei im Bereich ihrer Flanken dargestellt. Wie zu erkennen ist, geht das Signal an der Ader A von einem hohen Signalwert auf einen niedrigen Signalwert über, und das Signal an der Ader B geht vom niedrigen Signalwert auf den hohen Signalwert über. Dabei ist zu erkennen, daß das Signal an der Ader B eine wesentlich kleinere Amplitude als das Signal an der Ader A hat. Das stark vereinfachte Ersatzschaltbild des Busses läßt erkennen, daß zwischen den beiden Adern eine Kapazität C_{A/B} vorhanden ist, die eine gegenseitige Beeinflussung der beiden Signale zur Folge hat. Im Beispiel von Fig. 1 bewirkt der Signalübergang an der Ader A vom hohen Signalwert auf den niedrigen Signalwert, daß das Signal an der Ader B zunächst während der Zeitperiode Δt in die falsche Richtung "gezogen" wird, also nicht wie im idealen Fall vom niedrigen Signalwert auf den hohen Signalwert ansteigt, sondern auf niedrigere Werte übergeht. Erst nach der zeitlichen Verzögerung Δt beginnt das Signal an der Ader B in der erwünschten Weise anzusteigen.

In der Empfängerschaltung, in der die übertragenen digitalen Signale erkannt und ausgewertet werden, ergibt sich aufgrund des während der Zeitperiode Δt auftretenden Absinkens des Signalpegels an der Ader B eine zeitliche Verzögerung bei der Signalerkennung, da das übertragene Signal erst dann als gültig bestätigt werden kann, wenn die Pegelübergänge an beiden Adern des Busses festgestellt worden sind. Diese zeitliche Verzögerung führt zu einer Verlangsamung der Übertragung, die unerwünscht ist.

Der Erfindung liegt die Aufgabe zugrunde, eine Schaltungsanordnung der eingangs angegebenen Art zu schaffen, bei der die aufgrund der obigen Probleme auftretende Zeitverzögerung bei der Signalerkennung beseitigt wird.

Ein Ausführungsbeispiel der Erfindung wird nun unter Bezugnahme auf die Zeichnung näher erläutert. In der Zeichnung zeigen:
Fig. 1 ein Spannungs-Zeit-Diagramm zur Erläuterung des der Erfindung zugrunde liegenden Problems,
Fig. 2 ein stark vereinfachtes Ersatzschaltbild eines 2-Draht-Busses,
Fig. 3 ein Blockschaltbild der erfindungsgemäßen Schaltungsanordnung und
Fig. 4 ein Beispiel eines in der Schaltungsanordnung von Fig. 3 verwendbaren Filters.

Die in Fig. 3 dargestellte Schaltungsanordnung 10 enthält einen ersten Flankendetektor 12, der an einem Eingang 14 das an der Ader A des Busses übertragene Signal empfängt. Das von diesem Flankendetektor 12 abgegebene Signal wird einem Eingang einer ODER-Schaltung 16 zugeführt, deren Ausgang 18 den Signalausgang der zu beschreibenden Schaltungsanordnung bildet.

Ein zweiter Flankendetektor 20 empfängt an seinem Eingang 22 das an der Ader B des Busses übertragene Signal. Das von ihm abgegebene Signal wird dem zweiten Eingang der ODER-Schaltung 16 zugeführt.

Die von den Flankendetektoren 12 und 20 abgegebenen Signale werden auch an die Setz-Eingänge 24, 26 von zwei Flipflops 28 bzw. 30 angelegt. Die Ausgänge 32 und 34 der Flipflops 28 bzw. 30 sind mit zwei Eingängen einer Antivalenzschaltung 36 verbunden. Das Ausgangssignal dieser Antivalenzschaltung 36 wird an ein rückstellbares Laufzeitfilter 38 angelegt. Wie aus Fig. 3 zu erkennen ist, sind die Rücksetz-Eingänge 40 und 42 der beiden Flipflops 28 bzw. 30 miteinander verbunden, so daß über einen Eingang 44 an sie ein Rücksetzsignal angelegt werden kann.

Die in Fig. 3 dargestellte Schaltungsanordnung arbeitet wie folgt:

Bei der nachfolgenden Beschreibung wird angenommen, daß die oben anhand von Fig. 1 erläuterte Situation am Bus vorhanden ist, also die Unsymmetrie der auf den Adern A und B übertragenen Signale vorliegt und die kapazitive Kopplung zwischen den beiden Adern vorhanden ist.

Wenn am Eingang 14 des Flankendetektors 12 eine Signalflanke auftritt, die anzeigt, daß ein digitales Signal übertragen wird, dann kann der Flankendetektor 12 diese Flanke erkennen und demgemäß an seinem Ausgang ein Signal abgeben, das über die ODER-Schaltung 16 zum Ausgang 18 durchgeschaltet wird. Die an den Ausgang 18 angeschlossenen weiteren Schaltungen können somit praktisch ohne Verzögerung darüber informiert werden, daß die Übertragung eines digitalen Signals stattfindet.

Gleichzeitig bewirkt das Ausgangssignal des Flankendetektors 12 das Setzen des Flipflops 28, so daß dessen Ausgang 32 ein Signal mit hohem Signalwert abgibt. Das Signal an der Ader B, das den in Fig. 1 dargestellten Verlauf hat, kann vom Flankendetektor 20 während der Dauer Δt nicht als digitales Signal erkannt werden, so daß der Flankendetektor 20 erst später als der Flankendetektor 12 an seinem Ausgang durch Abgabe eines entsprechenden Signals das Erkennen des Signals an der Ader B anzeigt. Dies bewirkt, daß an der Antivalenzschaltung 36 nur an dem mit dem Ausgang 32 des Flipflops 28 verbundenen Eingang ein Signal mit hohem Wert anliegt, was wiederum zur Folge hat, daß die Antivalenzschaltung an ihrem Ausgang ein Signal mit hohem Wert abgibt, das das Laufzeitfilter 38 durchläuft. Sobald auch der Flankendetektor 20 das Auftreten der Signalflanke an der Ader B erkennt, bewirkt er das Setzen des Flipflops 30, so daß dieses Flipflop 30 dann an seinem Ausgang 34 ebenfalls ein Signal mit hohem Wert abgibt, das von der Antivalenzschaltung 36 empfangen wird.

Die Laufzeit des Laufzeitfilters 38 ist so festgelegt, daß sie höchstens gleich dem zeitlichen Abstand von zwei auf dem Bus übertragenen digitalen Signalen ist. Je höher die Übertragungsrate am Bus ist, desto kürzer muß daher die Laufzeit des Filters 38 eingestellt sein. Ein Beispiel eines solchen rückstellbaren Laufzeitfilters 38, wie es in der Schaltung von Fig. 3 verwendet werden kann, ist in Fig. 4 dargestellt. Wie zu erkennen ist, handelt es sich bei diesem Filter um einen einfachen Tiefpaß aus einem Widerstand R und einem Kondensator C, wobei parallel zum Widerstand eine Diode D geschaltet ist. Ohne die Diode D würde das Filter 38 an seinem Ausgang 46 das seinem Eingang zugeführte Signal nach einer durch die Zeitkonstante aus dem Widerstand R und dem Kondensator C festgelegten Verzögerungszeit rekonstruieren. Wenn aber am Eingang des Filters 38 während der Aufladezeit des Kondensators C wieder ein Signal mit niedrigem Signalwert erscheint, wird der Kondensator über die Diode D sofort wieder entladen, so daß am Ausgang 46 kein Signal mit hohem Wert abgegeben wird.

Wenn an der Antivalenzschaltung 36 ein Ausgangssignal vom Flipflop 30 ankommt, weil der Flankendetektor 20 inzwischen das Signal an der B festgestellt hat, dann endet das Ausgangssignal der Antivalenzschaltung 36, da ja am Ausgang 32 des Flipflops 38 ebenfalls bereits ein Ausgangssignal erzeugt worden ist, das von der Antivalenzschaltung 36 empfangen wird. Der gleichzeitige Empfang der beiden Signale von den Flipflops 28 und 30 an der Antivalenzschaltung 36 verhindert, daß das Laufzeitfilter 38 ein Ausgangssignal abgibt, weil, wie oben angegeben wurde, durch das Ausgangssignal der Antivalenzschaltung mit niedrigem Signalwert der Kondensator C im Filter 38 über die Diode D wieder entladen wird. Das am Ausgang 18 der ODER-Schaltung 16 abgegebene Signal von nachfolgenden Schaltungen kann daher als tatsächliches übertragenes Signal weiterverarbeitet werden kann. Wie bereits dargelegt wurde, hat der Kopplungseffekt zwischen den beiden Adern des Busses aufgrund der Kapazität C_{A/B} keine Verzögerung bei der Signalerkennung zur Folge, da zumindest ein Flankendetektor das übertragene digitale Signal sofort und verzögerungsfrei erkennen kann.

Der oben geschilderte Fall der verzögerungsfreien Erkennung gilt natürlich auch dann, wenn die Verhältnisse an den Adern A und B gegenüber Fig. 1 genau umgekehrt sind. In diesem Fall ist es das Ausgangssignal des Flankendetektors 20, das von der ODER-Schaltung 16 zum Ausgang 18 durchgeschaltet wird und anzeigt, daß ein digitales Eingangssignal übertragen wird.

Wenn nun in einem Störungsfall nur an einer der beiden Adern des Busses ein Störsignal auftritt, dann spricht nur der mit dieser Ader verbundene Flankendetektor auf dieses Störsignal an und erzeugt am Ausgang 18 ein Ausgangssignal. Der andere Flankendetektor empfängt dagegen kein Signal, so daß er demgemäß auch nicht das Setzen des ihm zugeordneten Flipflops bewirkt. Die Antivalenzschaltung 36 empfängt daher nur von einem Flipflop ein Ausgangssignal und bewirkt die Abgabe eines Signals an das Laufzeitfilter 38. Dieses Signal wird vom Laufzeitfilter 38 nach Ablauf seiner Verzögerungszeit an dessen Ausgang 46 reproduziert, und dieses Signal wird als Fehlersignal verwendet, das anzeigt, daß nur an einer Ader des Busses ein Signal aufgetreten ist, was ein sicheres Anzeichen für das Vorliegen einer Störung ist. Das Fehlersignal am Ausgang 36 kann in den nachfolgenden Schaltungen dazu benutzt werden, das am Ausgang 18 auftretende Signal als ungültiges Signal zu behandeln.

Die Flipflops 28 und 30 werden über die Rücksetz-Eingänge 40 bzw. 42 jeweils vor der Übertragung eines Signals zurückgesetzt. Dies kann einfach dadurch erreicht werden, daß das an den Eingang 44 angelegte Signal mit der Übertragungsrate der digitalen Signale am Bus synchronisiert wird.

Somit wurde gezeigt, daß mit der beschriebenen Schaltungsanordnung jeweils sehr schnell erkannt werden kann, daß ein digitales Signal am Bus übertragen wird. Für die Anzeige, daß diese Übertragung stattfindet, ist jeweils dasjenige Signal verantwortlich, das am schnellsten von einem der Flankendetektoren erkannt wird. Eine etwaige Verzögerung des entsprechenden Signals an der anderen Ader des Busses, die innerhalb der für die gesamte Übertragung tolerierbaren Grenzen liegt, führt nicht zu einer Verzögerung der Signalerkennung. Erst wenn die Verzögerung größer als eine für eine einwandfreie Übertragung tolerierbare Verzögerung wird oder wenn am jeweils anderen Bus überhaupt kein Signal auftritt, wird von der Schaltungsanordnung ein Fehlersignal erzeugt, das das Signal am Ausgang als ungültig kennzeichnet.

## Patentansprüche

1. Schaltungsanordnung für den Empfang von über einen 2-Draht-Bus übertragenen digitalen Signalen mit zwei Eingängen (14, 22) und einem Ausgang (18) sowie einem Flankendetektor (12, 20) an jedem Eingang (14, 22), der abhängig von einer an seinem Eingang auftretenden Signalflanke ein Ausgangssignal abgibt, gekennzeichnet durch eine Verknüpfungsschaltung (16), die jedes von einem Flankendetektor (12, 20) abgegebene Signal zum Ausgang (18) durchschaltet und eine Zeitmeßschaltung (28, 30, 36, 38), die den zeitlichen Abstand der von den Flankendetektoren (12, 20) abgegebenen Signale mißt und ein Fehlersignal abgibt, wenn der gemessene zeitliche Abstand größer als der maximale Flankenabstand zwischen zwei aufeinanderfolgenden digitalen Signalen am Bus ist, wobei das Auftreten eines Fehlersignals das zuvor empfangene digitale Signal als ungültig markiert.

2. Schaltungsanordnung nach Anspruch 1, dadurch gekennzeichnet, daß die Verknüpfungsschaltung (16) eine ODER-Schaltung ist.

3. Schaltungsanordnung nach Anspruch 1 oder 2, dadurch gekennzeichnet, daß die Zeitmeßschaltung zwei Flipflops (28, 30) enthält, von denen das eine (28) am Setzeingang (24) das von einem der Flankendetektoren (12) abgegebene Signal und das andere am Setzeingang (26) das vom anderen Flankendetektor (20) abgegebene Signal empfängt, ferner eine Antivalenzschaltung (36) enthält, die mit den Ausgängen (32, 34) der Flipflops (28, 30) verbundene Eingänge aufweist, und außerdem ein rückstellbares Laufzeitfilter (38) mit einer höchstens dem maximalen Flankenabstand entsprechenden Laufzeit enthält, das das Ausgangssignal der Antivalenzschaltung (36) empfängt und nur dann das Fehlersignal abgibt, wenn der Abstand der von der Antivalenzschaltung (36) empfangenen Ausgangssignale der Flipflops (28, 30) größer als seine Laufzeit ist.

4. Schaltungsanordnung nach Anspruch 3, dadurch gekennzeichnet, daß das Laufzeitfilter (38) ein Tiefpaßfilter mit einem Längswiderstand (R) und einem Querkondensator (C) ist, wobei der Längswiderstand eine Diode (D) parallelgeschaltet ist, deren Durchlaßrichtung vom Verbindungspunkt zwischen dem Längswiderstand (R) und dem Querkondensator (C) und Masse verläuft.
